# EUROPÄISCHE PATENTSCHRIFT

(11) **EP 3 341 233 B1**
(45) Veröffentlichungstag und Bekanntmachung des Hinweises auf die Patenterteilung: **27.03.2019**
(21) Anmeldenummer: 16751246.6
(22) Anmeldetag: 03.08.2016
(51) Int. Cl.: B60K 35/00, G06F 1/16, G02F 1/1333, H01L 51/00

(54) **BIEGBARE ANZEIGE ZUR DARSTELLUNG VON TIEFENINFORMATIONEN**
FLEXIBLE DISPLAY FOR DISPLAYING DEPTH INFORMATION
ÉCRAN D'AFFICHAGE FLEXIBLE POUR L'AFFICHAGE D'INFORMATIONS DE PROFONDEUR

(30) Priorität: 29.08.2015 DE 102015011403
(43) Veröffentlichungstag der Anmeldung: 04.07.2018
(73) Patentinhaber: Audi AG, 85045 Ingolstadt (DE)
(72) Erfinder: KLUG, Markus, 85057 Ingolstadt (DE)
(86) Internationale Anmeldenummer: PCT/EP2016/068501
(87) Internationale Veröffentlichungsnummer: WO 2017/036716

(56) Entgegenhaltungen:
- EP-A1- 2 669 771
- EP-A2- 2 648 066
- US-A1- 2007 063 921
- US-A1- 2013 076 612
- US-A1- 2014 035 942

## Beschreibung

Die vorliegende Erfindung betrifft ein Verfahren zum Anzeigen von Daten in mindestens zwei räumlichen Ebenen sowie eine Anzeige und ein Fahrzeug.

Zum Darstellen von Tiefeninformationen, d. h. Daten mit räumlicher bzw. dreidimensionaler Ausprägung, werden in der Regel 3D-Monitore verwendet, die besondere Brillen oder feste Blickwinkel voraussetzen. Weiterhin ist es auch möglich, verschiedene Anzeigen zu kombinieren, um dadurch einen Tiefeneffekt zu erzeugen.

So wird in der deutschen Druckschrift DE 1973 21 56 A1 eine Elektrolumineszenz-Anzeige zur Überlagerung einer analogen Anzeige vorgestellt.

In der US-amerikanischen Druckschrift US 2014 333 663 A1 werden mehrere sich überlagernde und teilweise opake Bildschirme zur Ausformung einer Anzeigevorrichtung offenbart.

Zueinander verschiebbare und hintereinander angeordnete Anzeigen mit transparenten Bereichen sind in der Druckschrift US 2007 063 921 A1 offenbart.

Ein Verfahren zum Anzeigen von Daten in mindestens zwei räumlichen Ebenen einer biegbaren Anzeige mit den Merkmalen des Oberbegriffs des Anspruchs 1 beziehungsweise eine Anzeige zum Anzeigen von Informationen in mindestens zwei räumlichen Ebenen mit den Merkmalen des Oberbegriffs des Anspruch 9 zeigt die EP 2 648 066 A2.

Vor diesem Hintergrund wird ein Verfahren zum Anzeigen von Daten in mindestens zwei räumlichen Ebenen einer biegbaren Anzeige vorgestellt, wobei die biegbare Anzeige derart gebogen wird, das mindestens ein erster Teil der Anzeige in einer zweiten Ebene aus Betrachtersicht hinter mindestens einem in einer ersten Ebene liegenden zweiten Teil der Anzeige positioniert wird, so dass auf dem mindestens einen ersten Teil der Anzeige mindestens Daten zu Tiefeninformationen von auf dem mindestens einen zweiten Teil der Anzeige dargestellten Daten dargestellt werden können.

Das vorgestellte Verfahren dient insbesondere zum Darstellen von Daten mit Tiefeninformationen unter Verwendung einer einzigen Anzeige in Form eines biegbaren Displays, wie bspw. einer OLED-Displayfolie. Dazu ist insbesondere vorgesehen, dass durch Eigenüberlagerung des Displays ein Tiefeneffekt erzeugt wird. Dies bedeutet, dass die erfindungsgemäß vorgesehene Anzeige sich in mehreren Ebenen selbst zumindest teilweise überlagert bzw. überlappt, so dass ein Betrachter der Anzeige durch einen jeweiligen zweiten Teil der Anzeige hindurch auf einen jeweiligen ersten Teil der Anzeige blicken kann. Dazu kann die Anzeige bspw. derart gebogen werden, dass der erste Teil der Anzeige, wie bspw. eine erste Hälfte der Anzeige, in einer zweiten Ebene hinter einen in einer ersten Ebene liegenden zweiten Teil der Anzeige, wie bspw. eine zweite Hälfte, positioniert wird.

Selbstverständlich können jeweilige Teile der Anzeige auch Teile sein, die kleiner sind als eine Hälfte der Anzeige, so dass hinter dem mindestens einen zweiten Teil nur abschnittsweise jeweilige erste Teile positioniert sind. Weiterhin kann auch eine Vielzahl von ersten und zweiten Teilen vorgesehen sein, so dass sich die Anzeige vielfach selbst überlagert. Entsprechend kann auch eine Vielzahl von Ebenen vorgesehen sein, in denen jeweilige erste und zweite Teile positioniert werden, wobei stets ein zweiter Teil der Anzeige von einem Betrachter als oberste Ebene wahrgenommen wird.

Unter "überlagern" ist im Kontext der vorliegenden Erfindung ein räumliches gegenseitiges Überdecken bzw. Überschneiden jeweiliger Teile einer Anzeige in verschiedenen Ebenen, d. h. aus Betrachtersicht über- oder untereinander, zu verstehen.

Es kann auch vorgesehen sein, dass ein zweiter Teil einer jeweiligen Anzeige aus Betrachtersicht vor einen jeweiligen ersten Teil der Anzeige gebogen wird.

Unter einer Betrachtersicht ist im Kontext der vorgestellten Erfindung eine Perspektive eines Betrachters einer jeweiligen Anzeige zu verstehen, die auf einen obersten zweiten Teil der Anzeige gerichtet ist, so dass der Betrachter jeweilige erste Teile der Anzeige durch den obersten zweiten Teil der Anzeige hindurch betrachtet. Entsprechend ist vorgesehen, dass jeweilige zweite und ggf. erste Teile der Anzeige zumindest teilweise transparent ausgestaltet sind.

Sobald verschiedene Teile der erfindungsgemäß vorgesehenen Anzeige sich gegenseitig überlagern, d. h. in verschiedenen räumlichen Ebenen zueinander stehen oder liegen, ist es möglich, auf den verschiedenen Teilen selektiv Informationen darzustellen, die sich auf den verschiedenen Teilen der Anzeige gegenseitig zu einem für einen alle Teile der Anzeige betrachtenden Nutzer stimmigen Gesamtbild ergänzen. Dabei ist insbesondere vorgesehen, dass auf einem in einer jeweiligen aus Betrachtersicht hinteren Ebene angeordneten Teil der Anzeige solche Informationen bzw. Daten dargestellt werden, die dem Nutzer einen Tiefeneindruck des Gesamtbildes vermitteln sollen. So kann bspw. vorgesehen sein, auf einem in einer jeweiligen vordersten Ebene angeordneten Teil der Anzeige, virtuelle Bedienelemente bzw. Benutzerschnittstellen, wie bspw. Knöpfe darzustellen, die Funktionen aktivieren, die in einer tieferen Ebene liegen und entsprechend auf dem Teil der Anzeige dargestellt werden, der in einer Ebene hinter der vordersten Ebene liegt.

Unter Tiefeninformationen sind im Kontext der vorliegenden Erfindung insbesondere solche Informationen bzw. Daten zu verstehen, die einer zweidimensionalen Information einen dreidimensionalen Eindruck verleihen.

Es ist ferner denkbar, dass auf einem jeweiligen ersten Teil einer jeweiligen Anzeige Daten dargestellt werden, die unabhängig von auf einem jeweiligen zweiten Teil der Anzeige dargestellten Daten sind. Selbstverständlich ist entsprechend auch denkbar, dass auf dem zweiten Teil der Anzeige Daten dargestellt werden, die unabhängig von auf dem ersten Teil der Anzeige dargestellten Daten sind, so dass auf dem ersten und dem zweiten Teil der Anzeige unabhängig voneinander Inhalte dargestellt werden können, wobei auch lediglich teilweise unabhängige Daten, d. h. sowohl Tiefeninformationen als auch unabhängige Daten, auf einem jeweiligen Teil der Anzeige dargestellt werden können.

In einer möglichen Ausgestaltung des vorgestellten Verfahrens ist vorgesehen, dass der mindestens eine erste Teil der Anzeige derart hinter den mindestens einen zweiten Teil der Anzeige verschoben wird, dass vorgegebene Punkte des mindestens einen zweiten Teils der Anzeige vor vorgegebenen Punkten des mindestens einen ersten Teils der Anzeige positioniert werden.

Um einen jeweiligen ersten Teil einer Anzeige in Bezug auf einen jeweiligen zweiten Teil der Anzeige auszurichten, kann vorgesehen sein, dass einem Nutzer, der die Anzeige biegt bzw. faltet, Orientierungspunkte dargestellt werden, die eine optimale Ausrichtung des zweiten Teils der Anzeige zu dem ersten Teil der Anzeige anzeigen, wenn die Orientierungspunkte bspw. deckungsgleich sind oder in einer geometrischen Ausrichtung zueinander stehen, während die verschiedenen Teile der Anzeige in verschiedenen Ebenen positioniert werden.

Selbstverständlich ist auch denkbar, dass eine aktuelle Ausrichtung eines jeweiligen ersten Teils einer Anzeige zu einem jeweiligen zweiten Teil der Anzeige mittels einer geeigneten Erfassungsvorrichtung, wie bspw. einem optischen oder einem mechanischen Sensor, erfasst und an ein Steuergerät gemeldet wird. Sobald das Steuergerät Informationen zur Ausrichtung des ersten Teils der Anzeige gegenüber dem zweiten Teil der Anzeige hat, kann das Steuergerät eine Ausgabe von Daten bzw. Informationen an die aktuelle Ausrichtung angepasst ausgeben und einen präzise an eine aktuelle Ausrichtung der Anzeige bzw. jeweiligen Teilen der Anzeige abgestimmten Tiefeneindruck für einen Nutzer erzeugen und/oder eine korrekte Ausrichtung jeweiliger Teile der Anzeige zueinander an den Nutzer rückmelden.

In einer weiteren möglichen Ausgestaltung des vorgestellten Verfahrens ist vorgesehen, dass der mindestens eine erste Teil der Anzeige über einen im Wesentlichen halbkreisförmigen Radius hinter den mindestens einen zweiten Teil der Anzeige verschoben wird.

Um einen jeweiligen ersten Teil einer Anzeige hinter einen jeweiligen zweiten Teil der Anzeige zu biegen, eignet sich eine im wesentlichen halbreisförmige Biegung entlang einem bspw. 180° Radius, so dass die Anzeige möglichst nicht geknickt und daher nicht beschädigt wird.

In einer weiteren möglichen Ausgestaltung des vorgestellten Verfahrens ist vorgesehen, dass der mindestens eine erste Teil der Anzeige hinter den mindestens einen zweiten Teil der Anzeige geklappt wird.

Um ein schnelles und präzises Ausrichten eines jeweils ersten Teils einer Anzeige zu einem zweiten Teil der Anzeige zu ermöglichen, eignen sich vorgegebene Klapp- bzw. Faltstellen, an denen die Anzeige geknickt bzw. geklappt oder gefaltet wird, so dass sich der erste Teil entlang einer vorgegebenen Bewegungsbahn gegenüber dem zweiten Teil verschiebt.

Selbstverständlich kann auch vorgesehen sein, dass ein zweiter Teil der Anzeige vor einen ersten Teil der Anzeige geklappt bzw. geknickt oder geschoben wird.

In einer weiteren möglichen Ausgestaltung des vorgestellten Verfahrens ist vorgesehen, dass jeweilige erste Teile der Anzeige und jeweilige zweite Teile der Anzeige unabhängig voneinander angesteuert werden, und ein erster Teil der Anzeige bspw. einen Hintergrund eines auf einem zweiten Teil der Anzeige dargestellten Vordergrunds darstellt.

Um einem Nutzer der Anzeige einen Tiefeneindruck auf einer jeweiligen Anzeige bereitzustellen, kann es vorteilhaft sein, dass jeweilige erste und zweite Teile der Anzeige getrennt voneinander angesteuert werden. Insbesondere bei Anwendungen in einem Fahrzeug kann es vorteilhaft sein, wenn ein Teil der Anzeige, wie bspw. ein erster Teil, für eine dynamische Anzeige verwendet wird, die ständig aktualisiert wird, und ein weiterer Teil der Anzeige, wie bspw. ein zweiter Teil der Anzeige, sich statisch verhält und dem Nutzer konstant Informationen anzeigt, die sich nicht oder nur sehr langsam ändern.

Weiterhin ist denkbar, dass durch ein zeitversetztes Schalten eines ersten Teils der Anzeige und eines zweiten Teils der Anzeige einem Nutzer ein 3D-Effekt dargestellt wird, bei dem unterschiedlichen Augen des Nutzers unterschiedliche Informationen dargeboten werden.

In einer weiteren möglichen Ausgestaltung des vorgestellten Verfahrens ist vorgesehen, dass auf dem mindestens einen ersten Teil der Anzeige darzustellende Informationen gespiegelt dargestellt werden, um einem jeweiligen Nutzer einen zu jeweiligen auf dem mindestens einen zweiten Teil der Anzeige dargestellten Informationen passenden Eindruck beim Betrachten des ersten Teils der Anzeige durch den mindestens einen zweiten Teil der Anzeige hindurch zu ermöglichen.

Da jeweilige auf einem hinter den zweiten Teil gebogenen ersten Teil dargestellte Daten von einem Nutzer spiegelverkehrt wahrgenommen würden, wenn die Daten nach einem Biegevorgang ihre Ausrichtung beibehalten würden, ist vorgesehen, dass die Ausrichtung der Daten, die auf dem ersten Teil anzuzeigen sind, nach bzw. während dem Biegevorgang gespiegelt werden, um von dem Nutzer korrekt interpretiert zu werden.

In einer weiteren möglichen Ausgestaltung des vorgestellten Verfahrens ist vorgesehen, dass der mindestens eine erste Teil der Anzeige den mindestens einen zweiten Teil der Anzeige lediglich teilweise überlagert und Informationen mit Tiefenunterschied in Bereichen dargestellt werden, in denen der mindestens eine erste Teil der Anzeige den mindestens einen zweiten Teil der Anzeige zumindest teilweise überlagert und Daten ohne Tiefeninformationen in einem Bereich dargestellt werden, in dem lediglich der mindestens eine zweite Teil der Anzeige für einen jeweiligen Nutzer sichtbar ist.

Selbstverständlich ist denkbar, dass der erste Teil der Anzeige lediglich teilweise hinter den zweiten Teil der Anzeige gebogen wird, so dass für einen jeweiligen Nutzer Bereiche mit Tiefeninformationen und Bereiche ohne Tiefeninformationen auf der Anzeige erkennbar sind. Dabei können die Bereiche des zweiten Teils der Anzeige, die einen jeweiligen ersten Teil der Anzeige nicht überlagern, zur Darstellung von 2D-Informationen verwendet werden, die bspw. mit Informationen, die in den Bereichen des zweiten Teils der Anzeige dargestellt werden, die den ersten Teil der Anzeige überlagern, interagieren und bspw. durch mit Tiefeninformationen dargestellte Steuerungsbefehle kontrolliert werden.

In einer weiteren möglichen Ausgestaltung des vorgestellten Verfahrens ist vorgesehen, dass eine Vielzahl von ersten Teilen der Anzeige hinter den zweiten Teil der Anzeige oder eine Vielzahl von zweiten Teilen der Anzeige verschoben wird.

Es ist denkbar, dass die erfindungsgemäße Anzeige mehrfach gebogen wird, so dass eine Vielzahl von Überlagerungsbereichen entsteht, die einem Nutzer eine Vielzahl von Bereichen mit Tiefeninformationen bereitstellt. Insbesondere kann auch vorgesehen sein, dass die Anzeige derart mehrfach gebogen wird, dass eine Vielzahl von sich abwechselnden ersten und zweiten Teilen der Anzeige entsteht. Dabei ist vorgesehen, dass jeweilige darzustellende Informationen durch jeweilige erste Teile stets normal und durch jeweilige zweite Teile stets in Bezug zu den jeweiligen ersten Teilen gespiegelt dargestellt werden.

Ferner betrifft die vorliegende Erfindung eine Anzeige zum Anzeigen von Informationen in mindestens zwei räumlichen Ebenen, wobei die Anzeige derart zu biegen ist, dass mindestens ein erster Teil der Anzeige in einer zweiten Ebene aus Betrachtersicht hinter mindestens einen in einer ersten Ebene liegenden zweiten Teil der Anzeige zu positionieren ist, so dass auf dem mindestens einen ersten Teil der Anzeige mindestens Tiefeninformationen von auf dem mindestens einen zweiten Teil der Anzeige darzustellenden Daten darzustellen sind.

Die vorgestellte Anzeige dient insbesondere zur Durchführung des vorgestellten Verfahrens.

In einer möglichen Ausgestaltung der vorgestellten Anzeige ist vorgesehen, dass auf einem jeweiligen zweiten Teil der Anzeige mindestens eine Benutzerschnittstelle angeordnet ist, die dazu konfiguriert ist, mindestens eine Funktion auf einem jeweiligen ersten Teil der Anzeige zu steuern, wobei die Anzeige ein Steuergerät umfasst, das dazu konfiguriert ist, auf dem ersten Teil der Anzeige darzustellende Informationen bzw. Daten und auf dem zweiten Teil der Anzeige darzustellende Daten aufeinander abzustimmen, so dass für einen Nutzer der Anzeige ein Tiefeneindruck entsteht.

Um jeweilige auf einem ersten und einem zweiten Teil einer Anzeige darzustellende Informationen so anzuordnen, dass für einen Nutzer ein stimmiger Gesamteindruck entsteht, müssen Inhalte eines jeweiligen zweiten Teils der Anzeige auf Inhalte eines jeweiligen ersten Teils der Anzeige bzw. Inhalte des ersten Teils der Anzeige auf Inhalte des zweiten Teils der Anzeige genau abgestimmt werden, d.h. insbesondere räumlich relativ zueinander ausgerichtet werden. Dazu ist vorgesehen, dass eine korrekte räumliche Ausrichtung des ersten Teils der Anzeige zu dem zweiten Teil der Anzeige bspw. mittels eines Sensors bei einer Kalibrierung erfasst und in einem von der Anzeige umfassten Steuergerät hinterlegt wird. Anhand der bekannten relativen räumlichen Ausrichtung des ersten Teils der Anzeige zu dem zweiten Teil der Anzeige kann das Steuergerät ggf. darzustellende Inhalte, d. h. darzustellende Daten in ihrer Ausrichtung auf dem ersten und/oder zweiten Teil der Anzeige korrigieren, so dass einem Nutzer ein präziser Tiefeneindruck entsteht.

In einer möglichen Ausgestaltung der vorgestellten Anzeige ist vorgesehen, dass mindestens der mindestens eine zweite Teil der Anzeige zumindest teilweise transparent ausgestaltet ist.

Um einem Betrachter der Anzeige Informationen durch einen jeweiligen Teil der Anzeige hindurch darzustellen, ist vorgesehen, dass jeweilige zweite Teile der Anzeige zumindest teilweise transparent ausgestaltet sind.

Ferner betrifft die vorliegende Erfindung ein Fahrzeug mit einer Anzeige zum Anzeigen von Informationen in mindestens zwei räumlichen Ebenen, wobei die Anzeige derart zu biegen ist, dass mindestens ein erster Teil der Anzeige in einer aus Betrachtersicht zweiten Ebene hinter mindestens einen in einer ersten Ebene liegenden zweiten Teil der Anzeige zu positionieren ist, so dass auf dem mindestens einen ersten Teil der Anzeige mindestens Tiefeninformationen von auf dem mindestens einen zweiten Teil der Anzeige darzustellenden Informationen darzustellen sind, wobei der mindestens eine erste Teil und/oder der mindestens eine zweite Teil der Anzeige entlang einer durch das Fahrzeug vorgegebenen Trajektorie zu verschieben ist. In einer möglichen Ausgestaltung des vorgestellten Fahrzeugs ist vorgesehen, dass die Trajektorie durch mindestens eine Schiene, in der die Anzeige zu verschieben ist, vorgegeben ist.

Mittels einer Schiene kann ein jeweiliger erster Teil gegenüber einem jeweiligen zweiten Teil einer jeweiligen Anzeige schnell und exakt verschoben werden.

In einer weiteren möglichen Ausgestaltung des vorgestellten Fahrzeugs ist vorgesehen, dass das Fahrzeug einen Stellantrieb umfasst, der dazu konfiguriert ist, einen Abstand zwischen dem mindestens einen ersten Teil der Anzeige und dem mindestens einen zweiten Teil der Anzeige automatisch und dynamisch in Abhängigkeit jeweiliger auf der Anzeige darzustellender Informationen einzustellen.

Da verschiedene Informationen verschiedene Tiefendimensionen erfordern, kann es sinnvoll sein, wenn ein Abstand zwischen erstem und zweitem Teil einer jeweiligen Anzeige angepasst wird.

Unter einer Schiene ist im Kontext der vorliegenden Erfindung jede technisch geeignete Leiteinrichtung zum Führen einer biegbaren Anzeige auf einer vorgegebenen Bahn bzw. Trajektorie, wenn die Anzeige gebogen wird, zu verstehen.

Weitere Vorteile und Ausgestaltungen der Erfindung ergeben sich aus der Beschreibung sowie den beiliegenden Zeichnungen.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand von Ausführungsformen in den Zeichnungen schematisch dargestellt und wird unter Bezugnahme auf die Zeichnungen schematisch und ausführlich beschrieben.
Figur 1 zeigt eine mögliche Ausgestaltung des vorgestellten Verfahrens, bei dem eine Anzeige gebogen wird.
Figur 2 zeigt eine mögliche Ausgestaltung des vorgestellten Verfahrens, bei dem eine Anzeige geknickt wird.
Figur 3 zeigt eine mögliche Ausgestaltung des vorgestellten Verfahrens, bei dem eine Anzeige mehrfach gebogen wird.

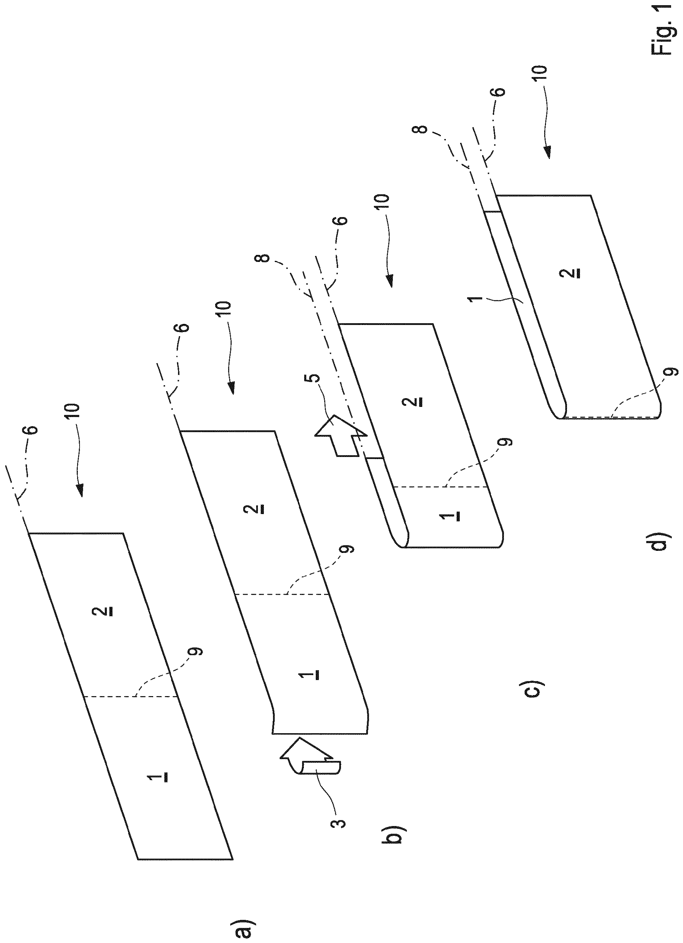

In Figur 1 ist eine Anzeige 10 mit einem ersten Teil 1 und einem zweiten Teil 2 gemäß einem Schritt a) dargestellt. In Schritt a) liegen der erste Teil 1 und der zweite Teil 2 in einer Ebene 6.

Um einem Nutzer der Anzeige 10 einen Tiefeninhalt, wie bspw. eine hinter einer digitalen Instrumententafel angezeigte Karte darzustellen, wird der erste Teil 1 der Anzeige 10 in einem Schritt b) gebogen, wie durch Pfeil 3 angedeutet, so dass der erste Teil 1 sich in eine zweite Ebene 8 hinter den zweiten Teil 2 der Anzeige 10 verschiebt. Sobald der erste Teil 1 sich in der zweiten Ebene 8 befindet, wird der erste Teil 1 in Relation zu dem zweiten Teil 2 ausgerichtet, wie in Schritt c) durch Pfeil 5 angedeutet. Um den ersten Teil 1 relativ zu dem zweiten Teil 2 auszurichten und eine präzise Anpassung von auf dem ersten Teil 1 darzustellenden Daten zu auf dem zweiten Teil 2 darzustellenden Daten zu ermöglichen, wird der erste Teil 1 solange in der Ebene 8 verschoben, bis sich der erste Teil 1 in einer vorgegebenen räumlichen Position relativ zu dem zweiten Teil 2 befindet und eine Markierung 9 sich bspw. exakt an einer Biegestelle zwischen dem ersten Teil 1 und dem zweiten Teil 2 befindet, wie in Schritt d) angedeutet.

Nachdem der erste Teil 1 hinter den zweiten Teil 2 gebogen wurde, wie in Schritt d) dargestellt, betrachtet der Nutzer die Anzeige 10 stets durch den zweiten Teil 2 hindurch. Dies bedeutet, dass der Nutzer den ersten Teil 1 durch den zweiten Teil 2 hindurch betrachtet, so dass der erste Teil 1 in Ebene 8 Tiefeninformationen für auf dem zweiten Teil 2 in Ebene 6 dargestellte Informationen bzw. Daten bereitstellen kann. Da der erste Teil 1 noch immer Teil der Anzeige 10 ist, müssen auf dem ersten Teil 1 darzustellende Informationen gegenüber den auf dem zweiten Teil 2 darzustellenden Informationen gespiegelt dargestellt werden. Entsprechend werden der erste Teil 1 und der zweite Teil 2 getrennt voneinander von einem oder mehreren Steuergeräten angesteuert. Entsprechend ist vorgesehen, dass der zweite Teil 2 zumindest teilweise transparent ist.

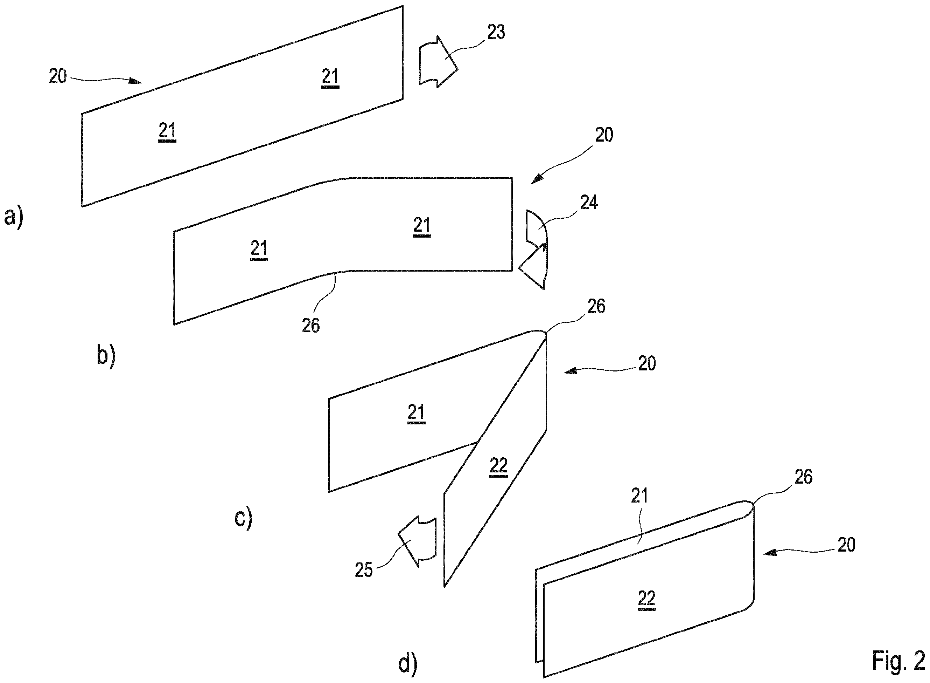

In Figur 2 ist der in Figur 1 beschriebene Vorgang mittels eines Faltvorgangs umgesetzt. Dies bedeutet, dass eine Anzeige 20 in einem ersten Schritt a) derart gefaltet wird, dass sich ein zweiter Teil 22 der Anzeige 20 gegenüber einem ersten Teil 21 der Anzeige 20 verschiebt, wie durch Pfeil 23 und Pfeil 24 in Schritt b) bzw. Pfeil 25 in Schritt c) angedeutet. Entsprechend wird der zweite Teil 22 solange verschoben, bis der zweite Teil 22 über dem ersten Teil 21 zu liegen kommt, wie in Schritt d) gezeigt. Dabei wird der zweite Teil 22 entlang einer vorgegebenen Trajektorie verschwenkt und muss nicht exakt ausgerichtet werden, da durch eine Position 26, an der die Anzeige 20 geknickt wird, die Trajektorie vorgegeben ist.

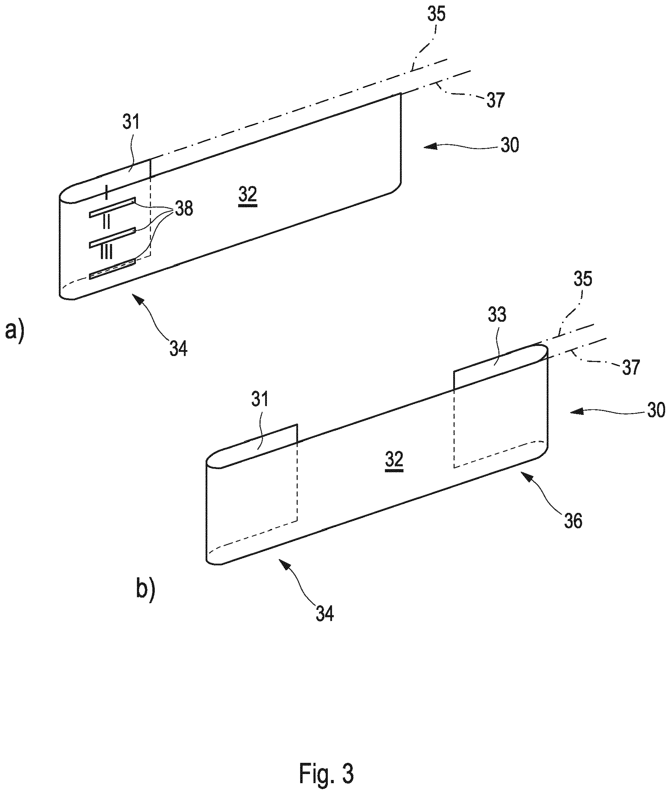

In Figur 3 ist eine Anzeige 30 mit einem zweiten Teil 32 dargestellt. Der zweite Teil 32 wurde in einem Schritt a) zunächst einmal gebogen, so dass ein erster Teil 31 der Anzeige 30 in einer von einem Betrachter aus hinteren Ebene 35 hinter dem zweiten Teil 32 positioniert ist. Durch die Positionierung des ersten Teils 31 hinter den zweiten Teil 32, der in einer vorderen Ebene 37 liegt, entsteht ein Überlagerungsbereich 34 von erstem Teil 31 und zweitem Teil 32. Der Abstand zwischen der hinteren Ebene 35 und der vorderen Ebene 37 kann in Abhängigkeit einer jeweiligen Funktion, insbesondere dynamisch und automatisch, geändert werden. Entsprechend liegt die hintere Ebene 35, je nach angestrebter Funktion, wenige Millimeter bis einige Zentimeter von der vorderen Ebene 37 entfernt.

In Schritt a) werden bspw. auf dem ersten Teil 31 der Anzeige 30 Funktionen I, II und III dargestellt, die über auf dem zweiten Teil 32 der Anzeige 30 dargestellte Bedienknöpfe 38 aktiviert werden können. Entsprechend wird einem jeweiligen Nutzer der Anzeige 30 durch die auf dem ersten Teil 31 der Anzeige 30 dargestellten Funktionen I, II und III ein Tiefeneindruck für die Bedienknöpfe 38 vermittelt, so dass der Nutzer den Eindruck erhält, dass die Bedienknöpfe von dem zweiten Teil 32 der Anzeige 30 in den ersten Teil 31 der Anzeige 30 hinein verschoben werden, wenn der Nutzer die Bedienknöpfe 38 berührt bzw. betätigt.

In einem Schritt b) wurde ein dritter Teil 33, als weiterer erster Teil der Anzeige 30 hinter den zweiten Teil 32 der Anzeige 30 gebogen, so dass zusätzlich zu dem Bereich 34 ein Bereich 36 entsteht, in dem Tiefeninformationen zu jeweiligen auf dem zweiten Teil 32 dargestellten Daten dargestellt werden können, wohingegen auf dem Teil des zweiten Teils 32, der nicht von dem ersten Teil 31 bzw. dem dritten Teil 33 überlagert ist, solche Informationen darzustellen sind, die keine Tiefeninformationen enthalten.

## Patentansprüche

1. Verfahren zum Anzeigen von Daten in mindestens zwei räumlichen Ebenen einer biegbaren Anzeige, **dadurch gekennzeichnet, dass** die biegbare Anzeige derart gebogen wird, das mindestens ein erster Teil der Anzeige in einer zweiten Ebene aus Betrachtersicht hinter mindestens einem in einer ersten Ebene liegenden zweiten Teil der Anzeige positioniert wird, so dass auf dem mindestens einen ersten Teil der Anzeige mindestens Daten zu Tiefeninformationen von auf dem mindestens einen zweiten Teil der Anzeige dargestellten Daten dargestellt werden können.

2. Verfahren nach Anspruch 1, wobei der mindestens eine erste Teil der Anzeige derart hinter den mindestens einen zweiten Teil der Anzeige verschoben wird, dass vorgegebene Punkte des mindestens einen zweiten Teils der Anzeige hinter vorgegebenen Punkten des mindestens einen ersten Teils der Anzeige positioniert werden.

3. Verfahren nach einem der Ansprüche 1 oder 2, wobei der mindestens eine erste Teil der Anzeige über einen im Wesentlichen halbkreisförmigen Radius hinter den mindestens einen zweiten Teil der Anzeige verschoben wird.

4. Verfahren nach einem der Ansprüche 1 oder 2, wobei der mindestens eine erste Teil der Anzeige über einen im Wesentlichen halbkreisförmigen Radius hinter den mindestens einen zweiten Teil der Anzeige verschoben wird.

5. Verfahren nach einem der voranstehenden Ansprüche, wobei der mindestens eine erste Teil der Anzeige und der mindestens eine zweite Teil der Anzeige zum Darstellen jeweiliger Informationen unabhängig voneinander angesteuert werden, und der mindestens eine erste Teil der Anzeige einen Hintergrund eines auf dem mindestens einen zweiten Teil der Anzeige dargestellten Vordergrunds darstellt.

6. Verfahren nach einem der voranstehenden Ansprüche, wobei auf dem mindestens einen ersten Teil der Anzeige darzustellende Informationen gespiegelt dargestellt werden, um einem jeweiligen Nutzer einen zu jeweiligen auf dem mindestens einen zweiten Teil der Anzeige dargestellten Informationen passenden Eindruck beim Betrachten des ersten Teils der Anzeige durch den mindestens einen zweiten Teil der Anzeige hindurch zu ermöglichen.

7. Verfahren nach einem der voranstehenden Ansprüche, wobei der mindestens eine erste Teil der Anzeige den mindestens einen zweiten Teil der Anzeige lediglich teilweise überlagert und Informationen mit Tiefenunterschied in Bereichen dargestellt werden, in denen der mindestens eine erste Teil der Anzeige den mindestens einen zweiten Teil der Anzeige zumindest teilweise überlagert und Daten ohne Tiefeninformationen in einem Bereich dargestellt werden, in dem lediglich der mindestens eine zweite Teil der Anzeige für einen jeweiligen Nutzer sichtbar ist.

8. Verfahren nach einem der voranstehenden Ansprüche wobei eine Vielzahl von ersten Teilen der Anzeige aus Betrachtersicht hinter den mindestens einen zweiten Teil der Anzeige oder eine Vielzahl von zweiten Teilen der Anzeige verschoben wird.

9. Anzeige zum Anzeigen von Informationen in mindestens zwei räumlichen Ebenen (6, 8, 35, 37), **dadurch gekennzeichnet, dass** die Anzeige (10, 20, 30) derart zu biegen ist, dass mindestens ein erster Teil (1, 21, 31) der Anzeige in einer zweiten Ebene (8, 35) aus Betrachtersicht hinter mindestens einen in einer ersten Ebene (6, 37) liegenden zweiten Teil (2, 22, 32) der Anzeige (10, 20, 30) zu positionieren ist, so dass auf dem mindestens einen ersten (1, 21, 31) Teil der Anzeige mindestens Tiefeninformationen von auf dem mindestens einen zweiten Teil (2, 22, 32) der Anzeige (10, 20, 30) darzustellenden Daten darzustellen sind.

10. Anzeige nach Anspruch 9, wobei auf dem mindestens einen zweiten Teil (2, 22, 32) der Anzeige (10, 20, 30) mindestens eine Benutzerschnittstelle (38) angeordnet ist, die dazu konfiguriert ist, mindestens eine Funktion auf dem mindestens einen ersten Teil (1, 21, 31) der Anzeige (10, 20, 30) zu steuern und wobei die Anzeige (10, 20, 30) ein Steuergerät umfasst, das dazu konfiguriert ist, auf dem mindestens einen ersten Teil (1, 21, 31) der Anzeige (10, 20, 30) darzustellende Informationen und auf dem mindestens einen zweiten Teil (2, 22, 32) der Anzeige (10, 20, 30) darzustellende Informationen aufeinander abzustimmen, so dass für einen Nutzer der Anzeige (10, 20, 30) ein Tiefeneindruck entsteht.

11. Anzeige nach Anspruch 9 oder 10, wobei mindestens der mindestens eine zweite Teil (2, 22, 32) der Anzeige (10, 20, 30) zumindest teilweise transparent ausgestaltet ist.

12. Fahrzeug mit einer Anzeige (10, 20, 30) zum Anzeigen von Informationen in mindestens zwei räumlichen Ebenen (6, 8, 35, 37), wobei die Anzeige (10, 20, 30) derart zu biegen ist, dass mindestens ein erster Teil (1, 21, 31) der Anzeige (10, 20, 30) in einer aus Betrachtersicht zweiten Ebene (8, 35) hinter mindestens einen in einer ersten Ebene (6, 37) liegenden zweiten Teil (2, 22, 32) der Anzeige (10, 20, 30) zu positionieren ist, so dass auf dem mindestens einen ersten Teil (1, 21, 31) der Anzeige (10, 20, 30) mindestens Tiefeninformationen von auf dem mindestens einen zweiten Teil (2, 22, 32) der Anzeige (10, 20, 30) darzustellenden Informationen darzustellen sind, wobei der mindestens eine erste Teil (1, 21, 31) und/oder der mindestens eine zweite Teil (2, 22, 32) der Anzeige (10, 20, 30) entlang einer durch das Fahrzeug vorgegebenen Trajektorie zu verschieben ist.

13. Fahrzeug nach Anspruch 12, wobei die Trajektorie durch mindestens eine Schiene, in der die Anzeige (10, 20, 30) zu verschieben ist, vorgegeben ist.

14. Fahrzeug nach Anspruch 12 oder 13, wobei das Fahrzeug einen Stellantrieb umfasst, der dazu konfiguriert ist, einen Abstand zwischen dem mindestens einen ersten Teil (1, 21, 31) der Anzeige (10, 20, 30) und dem mindestens einen zweiten Teil (2, 22, 32) der Anzeige (10, 20, 30) automatisch und dynamisch in Abhängigkeit jeweiliger auf der Anzeige (10, 20, 30) darzustellender Informationen einzustellen.

## Claims

1. Method for displaying data in at least two spatial planes of a flexible display, **characterised in that** the flexible display is bent such that at least one first portion of the display is positioned, from a viewer's perspective, in a second plane behind at least one second portion of the display positioned in a first plane, so that on the at least one first portion of the display at least data pertaining to depth information of data presented on the at least one second portion of display can be represented.

2. Method according to claim 1, wherein the at least one first portion of the display is moved behind the at least one second portion of the display such that prescribed points of the at least one second portion of the display are positioned behind prescribed points of the at least one first portion of the display.

3. Method according to claim 1 or 2, wherein the at least one first portion of the display is moved along a substantially semi-circular radius behind the at least one second portion of the display.

4. Method according to claim 1 or 2, wherein the at least one first portion of the display is moved over a substantially semi-circular radius behind the at least one second portion of the display.

5. Method according to any of the preceding claims, wherein the at least one first portion of the display and the at least one second portion of the display for representing respective information are controlled independently of one another, and the at least one first portion of the display represents a background of a foreground represented on the at least one second portion of the display.

6. Method according to any of the preceding claims, wherein on the at least one first portion of the display information to be displayed is represented in mirror form, in order to give a respective user a suitable impression of the respective information shown on the at least one second portion of the display when viewing the first portion of the display through the at least one second portion of the display.

7. Method according to any of the preceding claims, wherein the at least one first portion of the display only partly overlayers the at least one second portion of the display and information is presented with a depth difference in areas in which the at least one first portion of the display at least partly overlayers the at least one second portion of the display and data is presented without depth information in an area in which only the at least one second portion of the display is visible to a respective user.

8. Method according to any of the preceding claims, wherein a plurality of first portions of the display is moved, from the viewer's perspective, behind the at least one second portion of the display or a plurality of second portions of the display is moved.

9. Display for displaying information in at least two spatial planes (6, 8, 35, 37), **characterised in that** the display (10, 20, 30) is bent in such a way that at least one first portion (1, 21, 31) of the display is positioned in a second plane (8, 35), from the viewer's perspective, behind at least one second portion (2, 22, 32) of the display (10, 20, 30) lying in a first plane (6, 37), so that on the at least one first (1, 21, 31) portion of the display at least depth information is represented of data to be represented on the at least one second portion (2, 22, 32) of the display (10, 20, 30).

10. Display according to claim 9, wherein on the at least one second portion (2, 22, 32) of the display (10, 20, 30) at least one user interface (38) is arranged which is configured to control at least one function on the at least one first portion (1, 21, 21) of the display (10, 20, 30) and wherein the display (10, 20, 30) comprises a control device which is configured to coordinate information to be represented on the at least one first portion (1, 21, 31) of the display (10, 20, 30) and information to be represented on the at least one second portion (2, 22, 32) of the display (10, 20, 30), so that the user of the display (10, 20, 30) has an impression of depth.

11. Display according to claim 9 or 10, wherein at least the at least one second portion (2, 22, 32) of the display (10, 20, 30) is configured to be at least partially transparent.

12. Vehicle with a display (10, 20, 30) for displaying information in at least two spatial planes (6, 8, 35, 37), wherein the display (10, 20, 30) is bent such that at least one first portion (1, 21, 31) of the display (10, 20, 30) is positioned, from a viewer's perspective, in a second plane (8, 35) behind at least one second portion (2, 22, 32) of the display (10, 20, 30) lying in the first plane (6, 37), so that on the at least one first portion (1, 21, 31) of the display (10, 20, 30) at least depth information of information to be represented is represented on the at least one second portion (2, 22, 32) of the display (10, 20, 30), wherein the at least one first portion (1, 21, 31) and/or the at least one second portion (2, 22, 32) of the display (10, 20, 30) is moved along a trajectory predefined by the vehicle.

13. Vehicle according to claim 12, wherein the trajectory is predefined by at least one track, in which the display (10, 20, 30) is to be displaced.

14. Vehicle according to claim 12 or 13, wherein the vehicle comprises an actuator which is configured to adjust a distance between the at least one first portion (1, 21, 31) of the display (10, 20, 30) and the at least one second portion (2, 22, 32) of the display (10, 20, 30) automatically and dynamically as a function of respective information to be represented on the display (10, 20, 30).

## Revendications

1. Procédé d'affichage de données dans au moins deux plans spatiaux d'un écran d'affichage flexible, **caractérisé en ce que** l'écran d'affichage flexible est fléchi de sorte qu'au moins une première partie de l'écran d'affichage est positionnée dans un deuxième plan du point de vue de l'observateur derrière au moins une deuxième partie de l'écran d'affichage située dans un premier plan, de sorte qu'au moins des données sur des informations de profondeur de données représentées sur l'au moins une deuxième partie de l'écran d'affichage peuvent être affichées sur l'au moins une première partie de l'écran d'affichage.

2. Procédé selon la revendication 1, dans lequel l'au moins une première partie de l'affichage est décalée derrière l'au moins une deuxième partie de l'écran d'affichage de sorte que des points prédéfinis de l'au moins une deuxième partie de l'affichage sont positionnés derrière des points prédéfinis de l'au moins une première partie de l'écran d'affichage.

3. Procédé selon l'une quelconque des revendications 1 ou 2, dans lequel l'au moins une première partie de l'écran d'affichage est décalée sur un rayon sensiblement semi-circulaire derrière l'au moins une deuxième partie de l'écran d'affichage.

4. Procédé selon l'une quelconque des revendications 1 ou 2, dans lequel l'au moins une première partie de l'écran d'affichage est décalée sur un rayon sensiblement semi-circulaire derrière l'au moins une deuxième partie de l'écran d'affichage.

5. Procédé selon l'une quelconque des revendications précédentes, dans lequel l'au moins une première partie de l'écran d'affichage et l'au moins une deuxième partie de l'écran d'affichage sont commandées indépendamment l'une de l'autre pour la représentation d'informations respectives, et l'au moins une première partie de l'écran d'affichage représente un fond d'un avant-plan représenté sur l'au moins une deuxième partie de l'écran d'affichage.

6. Procédé selon l'une quelconque des revendications précédentes, dans lequel des informations à représenter sur l'au moins une première partie de l'écran d'affichage sont représentées miroitées pour permettre à un utilisateur respectif d'avoir une impression adaptée à des informations respectives représentées sur l'au moins une deuxième partie de l'écran d'affichage lors de l'observation de la première partie de l'écran d'affichage par l'au moins une deuxième partie de l'écran d'affichage.

7. Procédé selon l'une quelconque des revendications précédentes, dans lequel l'au moins une première partie de l'écran d'affichage recouvre seulement en partie l'au moins une deuxième partie de l'écran d'affichage et des informations sont représentées avec une différence de profondeur dans les zones dans lesquelles l'au moins une première partie de l'écran d'affichage recouvre au moins en partie l'au moins une deuxième partie de l'écran d'affichage et des données sans informations de profondeur sont représentées dans une zone, dans laquelle seule l'au moins une deuxième partie de l'écran d'affichage est visible pour un utilisateur respectif.

8. Procédé selon l'une quelconque des revendications précédentes, dans lequel une pluralité de premières parties de l'écran d'affichage est décalée du point de vue de l'utilisateur derrière l'au moins une deuxième partie de l'écran d'affichage ou une pluralité de deuxièmes parties de l'écran d'affichage.

9. Écran d'affichage pour l'affichage d'informations dans au moins deux plans spatiaux (6, 8, 35, 37), **caractérisé en ce que** l'écran d'affichage (10, 20, 30) doit être fléchi de sorte qu'au moins une première partie (1, 21, 31) de l'écran d'affichage doit être positionnée dans un deuxième plan (8, 35) du point de vue de l'observateur derrière au moins une deuxième partie (2, 22, 32) de l'écran d'affichage (10, 20, 30) située dans un premier plan (6, 37), de sorte qu'au moins des informations de profondeur de données à représenter sur l'au moins une deuxième partie (2, 22, 32) de l'écran d'affichage (10, 20, 30) doivent être affichées sur l'au moins une première partie (1, 21, 31) de l'écran d'affichage.

10. Écran d'affichage selon la revendication 9, dans lequel au moins une interface utilisateur (38) est agencée sur l'au moins une deuxième partie (2, 22, 32) de l'écran d'affichage (10, 20, 30), qui est configurée pour commander au moins une fonction sur l'au moins une première partie (1, 21, 31) de l'écran d'affichage (10, 20, 30) et dans lequel l'affichage (10, 20, 30) comprend un appareil de commande qui est configuré pour coordonner des informations à représenter sur l'au moins une première partie (1, 21, 31) de l'écran d'affichage (10, 20, 30) et des informations à représenter sur l'au moins une deuxième partie (2, 22, 32) de l'écran d'affichage (10, 20, 30) de sorte à créer une impression de profondeur pour un utilisateur de l'écran d'affichage (10, 20, 30).

11. Écran d'affichage selon la revendication 9 ou 10, dans lequel au moins l'au moins une deuxième partie (2, 22, 32) de l'écran d'affichage (10, 20, 30) est configurée au moins en partie de manière transparente.

12. Véhicule avec un écran d'affichage (10, 20, 30) pour l'affichage d'informations dans au moins deux plans spatiaux (6, 8, 35, 37), dans lequel l'écran d'affichage (10, 20, 30) doit être fléchi de sorte qu'au moins une première partie (1, 21, 31) de l'écran d'affichage (10, 20, 30) doit être positionnée dans un deuxième plan (8, 35) du point de vue de l'observateur derrière au moins une deuxième partie (2, 22, 32) de l'écran d'affichage (10, 20, 30) située dans un premier plan (6, 37), de sorte qu'au moins des informations de profondeur de données à représenter sur l'au moins une deuxième partie (2, 22, 32) de l'écran d'affichage (10, 20, 30) doivent être affichées sur l'au moins une première partie (1, 21, 31) de l'écran d'affichage (10, 20, 30), dans lequel l'au moins une première partie (1, 21, 31) et/ou l'au moins une deuxième partie (2, 22, 32) de l'écran d'affichage (10, 20, 30) doit être décalée le long d'une trajectoire prédéfinie par le véhicule.

13. Véhicule selon la revendication 12, dans lequel la trajectoire est prédéfinie par au moins un rail, dans lequel l'écran d'affichage (10, 20, 30) doit être décalé.

14. Véhicule selon la revendication 12 ou 13, dans lequel le véhicule comprend un actionneur, qui est configuré pour régler automatiquement et dynamiquement une distance entre l'au moins une première partie (1, 21, 31) de l'écran d'affichage (10, 20, 30) et l'au moins une deuxième partie (2, 22, 32) de l'écran d'affichage (10, 20, 30) en fonction d'informations respectives à représenter sur l'écran d'affichage (10, 20, 30).
